(19)

Europäisches
Patentamt
European
Patent Office
Office européen
des brevets

(11) **EP 3 142 250 A1**

(12) **EUROPEAN PATENT APPLICATION**

(43) Date of publication:
**15.03.2017 Bulletin 2017/11**

(51) Int Cl.:
***H03F 1/32*** *(2006.01)*

(21) Application number: **15184887.6**

(22) Date of filing: **11.09.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(71) Applicant: **Catena Holding bv
2628 XG Delft (NL)**

(72) Inventor: **Jansson, Lars Gustaf
164 46 Kista (SE)**

(74) Representative: **Schouten, Marcus Maria
NXP B.V.
Intellectual Property & Licensing
High Tech Campus 60
5656 AG Eindhoven (NL)**

(54) **AMPLIFIER LINEARIZATION**

(57)     An amplifier (150) comprising a first transistor (101) and a second transistor (102) connected in parallel. The second transistor (102) is configured to linearize the amplifier (150) by reducing third order non-linearity from the first transistor (101) by operating in the sub-threshold mode when the first transistor is biased in a saturation mode. A programmable voltage divider (120) is provided connecting an input node (111, 112) to the gate of the first transistor (101) or the gate of the second transistor (102) for tuning an amount of input signal applied at the gate of the first transistor (101) relative to an amount of the input signal applied at the gate of the second transistor (102).

Fig. 5

EP 3 142 250 A1

**Description**

Field

The disclosure relates to a linearization method for an amplifier and to a linearized amplifier.

Background

An ideal amplifier does not introduce distortion. One source of distortion in prior art amplifiers is non-linearity. Techniques designed to avoid or minimise non-linearity in amplifier response are referred to as linearization techniques. One known technique is referred to as derivative superposition.

In this method a first and second transistor are provided in parallel. The first transistor is biased in a saturation region, and the second transistor is biased in a transition region. The biasing and design parameters (e.g. channel widths) of the first and second transistor may be arranged such that the third order non-linear components from the first and second transistor cancel each other out. The first transistor (biased in a saturation region) has a negative third order non-linear component, and the second transistor (biased in a transition region) has a positive third order non-linear component.

Although devices based on this approach are useful, distortion can still be a problem. For example, the cancellation of the third order non-linear component may be sensitive to the matching between the first and second transistor. Process variation may result in increased non-linearity, because the cancellation of the non-linear components from the first and second transistor may rely on precise matching of the first and second transistors.

Summary

According to a first aspect, there is an amplifier comprising a first transistor and a second transistor connected in parallel. The source of the first transistor may be coupled to the source of the second transistor, and the drain of the first transistor is coupled to the drain of the second transistor.

The second transistor is configured to linearize the amplifier by reducing third order non-linearity from the first transistor by operating in the sub-threshold mode when the first transistor is biased in a saturation mode.

The amplifier further comprises a programmable voltage divider connecting an input node to the gate of the first transistor or the gate of the second transistor for tuning an amount of input signal applied at the gate of the first transistor relative to an amount of the input signal applied at the gate of the second transistor.

The programmable voltage divider may be a first programmable voltage divider connected to the gate of the first transistor. A second programmable voltage divider may be connected to the gate of the second transistor.

The programmable voltage divider may be a capacitive voltage divider.

The programmable voltage divider may comprise a non-variable capacitor connected in series with a variable capacitor.

The programmable voltage divider may comprise a first and second variable capacitor, connected in series.

The amplifier may further comprise a cascode transistor, connected in series with the first and second transistor.

The amplifier may further comprise a transformer that inductively couples the total current flowing through the first and second transistor to an output node of the amplifier.

The amplifier of any preceding claim may further comprise a controller configured to adjust the programmable voltage divider to improve linearization by at least partially compensating for at least one of process, temperature and voltage variations that result in incomplete cancellation of third order non-linearity.

The amplifier may further comprise a temperature sensor for monitoring a temperature of the amplifier, the controller being responsive to an output from the temperature sensor to compensate for temperature variation.

According to a second aspect, there is provided a method of operating an amplifier, so as to minimise third order non-linearity, comprising: biasing a first and second transistor such that a third order non-linearity contributed by the second transistor is at least partially cancelled by a third order non-linearity contributed by the first transistor; and

using a programmable voltage divider to tune an amount of an input signal applied at the gate of the first transistor relative to an amount of the input signal applied at the gate of the second transistor.

The amplifier may be in accordance with the first aspect.

The method may further comprise measuring a characteristic of the amplifier, and adjusting the programmable voltage divider in response to the measured characteristic.

The amplifier may comprise a self-test module for measuring a characteristic indicating a degree of third order non-linearity.

These and other aspects of the invention will be apparent from, and elucidated with reference to, the embodiments described hereinafter.

Brief description of Drawings

Embodiments will be described, by way of example only, with reference to the drawings, in which:

figure 1 is a schematic circuit diagram of an amplifier employing derivative superposition;
figure 2 is a schematic circuit diagram of an amplifier according to an embodiment, in which a programmable voltage divider is used at the gate of the first transistor and a fixed voltage divider is used at the gate of the second transistor;

figure 3 is a schematic circuit diagram of an amplifier according to an alternative embodiment, in which a programmable voltage divider is used only at the gate of the second transistor;

figure 4 is a schematic circuit diagram of an amplifier according to an embodiment, in which a first programmable voltage divider is used at the gate of the first transistor and a second programmable voltage divider is used at the gate of the second transistor;

figure 5 is a schematic circuit diagram of a further amplifier according to an embodiment.

It should be noted that the figures are diagrammatic and not drawn to scale. Relative dimensions and proportions of parts of these figures have been shown exaggerated or reduced in size, for the sake of clarity and convenience in the drawings. The same reference signs are generally used to refer to corresponding or similar feature in modified and different embodiments.

Detailed description of embodiments

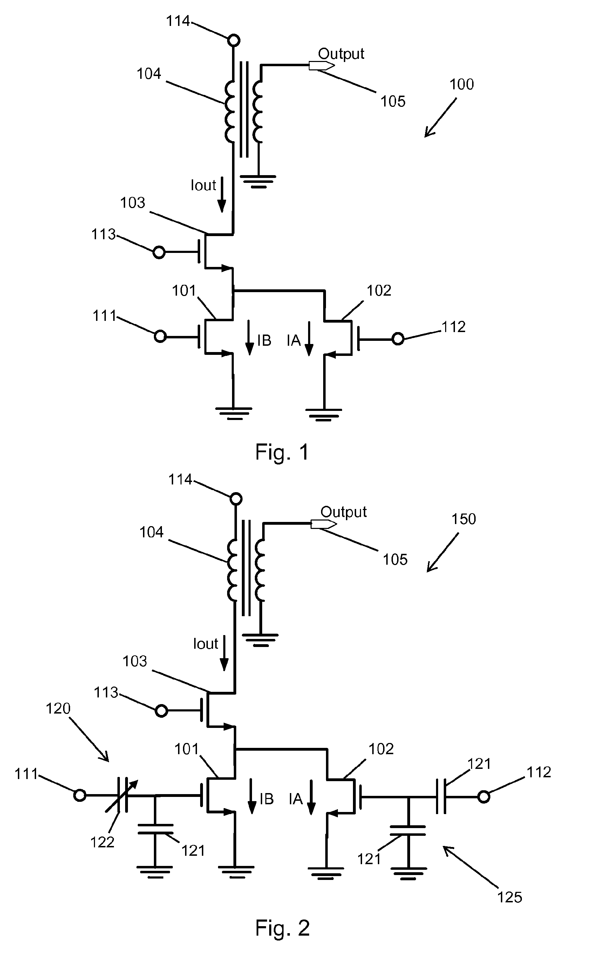

Figure 1 shows an amplifier 100, comprising a transformer 104, cascode transistor 103, first transistor 101 and second transistor 102. A biasing circuit (not shown) applies a bias voltage to the gate 111, 112 of the respective first and second transistors 101, 102. The biasing circuit may be configured to produce a bias voltage offset between the gates 111, 112 of the first and second transistors 101, 102, with the result that the first transistor is biased in a saturation region (class A or class AB), while the second transistor is biased in a sub-threshold region (class B).

A Taylor series expansion of the signal current around the bias point for the first and second transistors 101, 102 can be written as:

$$i_D = g_1 v_{GS} + g_2 v_{gs}{}^2 + g_3 v_{gs}{}^3 + \ldots.$$

Since the first transistor 101 is biased in the saturation region, the third order signal coefficient $g_3$ contributed by the first transistor 101 will be negative. Conversely, since the second transistor 102 is biased in the sub-threshold region, the third order signal coefficient $g_3$ contributed by the second transistor 102 will be negative. The channel width of the second transistor 102 may be adjusted, relative to the that of the first transistor 101, so that the third order signals from the first and second transistors 101, 102 substantially cancels out.

If the first and second transistors 101, 102 do not have the proper relative configuration (e.g. channel width), their third order signal contributions may not cancel out, resulting in harmonic distortion in the output of the amplifier 100.

Figure 2 shows an amplifier 150 according to an embodiment, which includes all the features of the amplifier 100 of figure 1, but which further includes a programmable capacitive voltage divider 120 coupled to the gate of the first transistor 101. A fixed ratio capacitive voltage divider 125 is connected to the gate of the second transistor 102. A first bias voltage may be provided at the gate of the first transistor 101 for biasing the first transistor 101 in a saturation mode. A second bias voltage may be provided at the gate of the second transistor 102 for biasing the second transistor 102 in a sub-threshold mode.

The programmable capacitive voltage divider 120 may comprise a fixed capacitor 121 and a variable capacitor 122 connected together in series. In other embodiments the programmable voltage divider 120 may comprise two variable capacitors connected together in series. A central node of the voltage divider 120 is connected to the gate of the first transistor 101, a first end node is connected to ground, and a second end node 111 is for receiving the input signal.

The input nodes 111, 112 are for receiving an input signal (e.g. an RF signal). The amount of the signal that is applied at the gate of the first transistor 101 is reduced according to the ratio of the capacitance of the adjustable capacitor 122 and fixed capacitor 121 of the voltage divider 120. Similarly, an amount of the input signal that is applied at the gate of the second transistor 102 is reduced according to the ratio of the capacitors in the fixed voltage divider 125. Adjusting the variable capacitor 122 results in a change in the amount of input signal applied to the gate of the first transistor 101 relative to the gate of the second transistor 102, which can be used to further linearize the amplifier 150, for example by compensating for errors in the matching of third order contributions from the first and second transistor 101, 102.

For example, the programmable voltage divider 120 may be used to compensate for process variations, which may result in the actual geometry of the channel of the first and/or second transistor being slightly different from their nominal (designed) values. Alternatively or additionally, the programmable voltage divider 120 may be used to compensate for temperature variations, which may de-tune the linearization of the amplifier. Alternatively or additionally, the programmable voltage divider 120 may be used to compensate for voltage variations, such as drift in the bias voltages applied to the first and/or second transistors 101, 102.

The amplifier 150 may be used in a device that includes a temperature sensor. A controller may be provided for tuning the programmable voltage divider 120 in response to an output from the temperature sensor, so as to compensate for temperature variation.

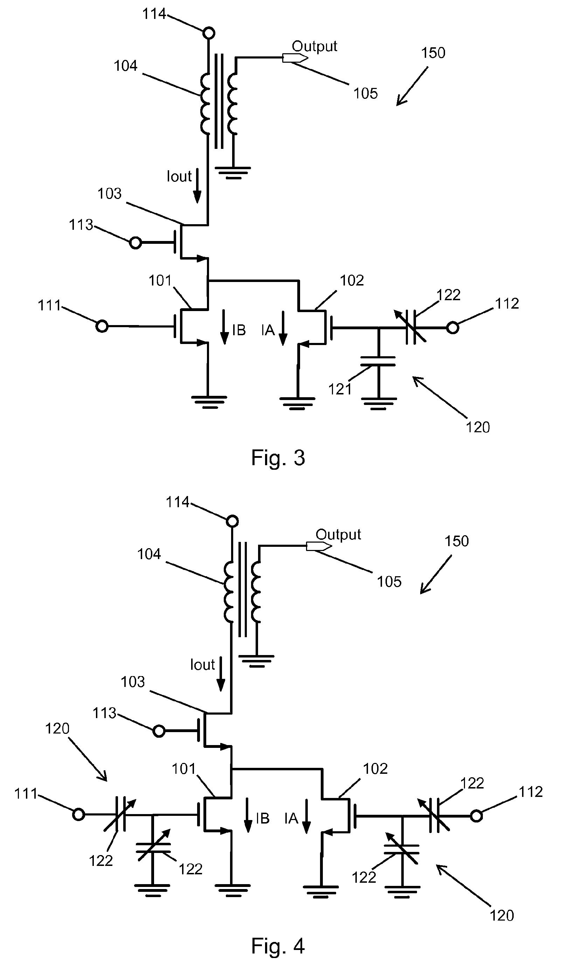

Figure 3 shows an alternative embodiment, in which the voltage divider connecting the input node 111 to the gate of the first transistor 101 is omitted, and a programmable voltage divider 120 is provided connecting the input node 112 to the gate of the second transistor 102. Such an arrangement may require a larger channel width for the second transistor 102 to compensate for the reduced input signal at the gate of the second transistor 102 (with no corresponding reduction at the gate of the first transistor 101). The variable capacitor 122 may be adjusted to improve linearization, by varying the relative proportions of input signals at the gates of the first and second transistors 101, 102.

In an alternative embodiment, a programmable voltage divider 120 may be provided only at the input to the first transistor 101, In such an arrangement the channel width of the second transistor may be narrower.

Figure 4 shows an alternative arrangement, in which programmable voltage dividers 120 are provided coupling the input signal to the gates of the first and second transistors 101, 102. In this example both programmable voltage dividers comprise a pair of variable capacitors 122.

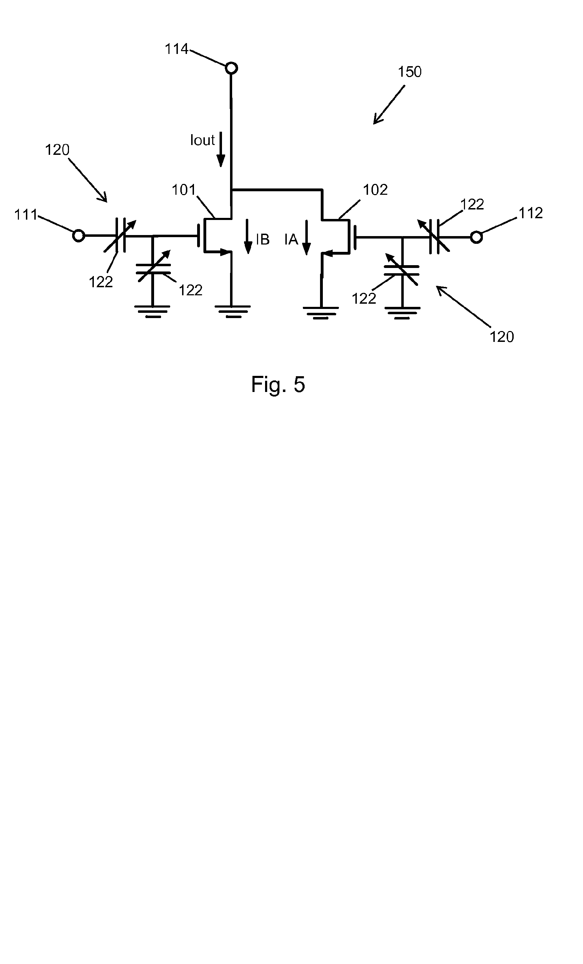

Figure 5 shows an alternative amplifier, in which the cascode transistor is omitted, along with the transformer 104. These are both optional features that are not essential. The skilled person will appreciate that the present invention is applicable to any device that includes parallel transistors configured for matched operation, and more specifically for tuning parallel transistors operating as class A(AB) and class (B) devices. Embodiments may provide an additional degree of freedom to design and operate such devices.

From reading the present disclosure, other variations and modifications will be apparent to the skilled person. Such variations and modifications may involve equivalent and other features which are already known in the art of amplifiers and linearization, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, and reference signs in the claims shall not be construed as limiting the scope of the claims.

**Claims**

1. An amplifier comprising a first transistor and a second transistor connected in parallel;
   wherein the second transistor is configured to linearize the amplifier by reducing third order non-linearity from the first transistor by operating in the subthreshold mode when the first transistor is biased in a saturation mode; and further comprising a programmable voltage divider connecting an input node to the gate of the first transistor or the gate of the second transistor for tuning an amount of input signal applied at the gate of the first transistor relative to an amount of the input signal applied at the gate of the second transistor.

2. The amplifier of claim 1, wherein the programmable voltage divider is a first programmable voltage divider connected to the gate of the first transistor; and a second programmable voltage divider is connected to the gate of the second transistor.

3. The amplifier of claim 1 or 2, wherein the programmable voltage divider is a capacitive voltage divider.

4. The amplifier of claim 3, wherein the programmable voltage divider comprises a non-variable capacitor connected in series with a variable capacitor.

5. The amplifier of any of claims 1 to 3, wherein the programmable voltage divider comprises a first and second variable capacitor, connected in series.

6. The amplifier of any preceding claim, wherein the amplifier further comprises a cascode transistor, connected in series with the first and second transistor.

7. The amplifier of any preceding claim, wherein the amplifier further comprises a transformer that inductively couples the total current flowing through the first and second transistor to an output node of the amplifier.

8. The amplifier of any preceding claim, further comprising a controller configured to adjust the programmable voltage divider to improve linearization by at least partially compensating for at least one of process, temperature and voltage variations that result in incomplete cancellation of third order non-linearity.

9. The amplifier of claim 8, wherein the amplifier further comprises a temperature sensor for monitoring a temperature of the amplifier, the controller being responsive to an output from the temperature sensor to compensate for temperature variation.

**10.** A method of operating an amplifier, so as to minimise third order non-linearity, comprising: biasing a first and second transistor such that a third order non-linearity contributed by the second transistor is at least partially cancelled by a third order non-linearity contributed by the first transistor; and
using a programmable voltage divider to tune an amount of an input signal applied at the gate of the first transistor relative to an amount of the input signal applied at the gate of the second transistor.

**11.** The method of claim 10, wherein the amplifier is in accordance with any of claims 1 to 10.

**12.** The method of claim 10, further comprising measuring a characteristic of the amplifier, and adjusting the programmable voltage divider in response to the measured characteristic.

**13.** The method of claim 12, wherein the amplifier comprises a self-test module for measuring a characteristic indicating a degree of third order non-linearity.

Fig. 1

Fig. 2

Fig. 3

Fig. 4

Fig. 5

Europäisches
Patentamt

European
Patent Office

Office européen
des brevets

# EUROPEAN SEARCH REPORT

Application Number

EP 15 18 4887

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 8 456 241 B1 (LEONG POH BOON [SG] ET AL) 4 June 2013 (2013-06-04)<br>* abstract *<br>* figures 1a,1b,2 *<br>----- | 1-13 | INV.<br>H03F1/32 |
| Y | NAJARI O E ET AL: "Wideband inductorless LNA employing simultaneous 2nd and 3rd order distortion cancellation",<br>NORCHIP, 2010, IEEE, PISCATAWAY, NJ, USA,<br>15 November 2010 (2010-11-15), pages 1-4,<br>XP031836283,<br>ISBN: 978-1-4244-8972-5<br>* abstract *<br>* pages 1,5; figures 1,5 *<br>* I. INTRODUCTION *<br>* II. Proposed Distortion Cancellation Technique *<br>* III. Wideband Noise Cancellation Design *<br>----- | 1-12 | |
| Y | US 2008/204142 A1 (KANG BYOUNG-JOONG [KR]) 28 August 2008 (2008-08-28)<br>* abstract *<br>* figures 4,5a,5b *<br>* paragraphs [0047] - [0063] *<br>----- | 1-13 | TECHNICAL FIELDS SEARCHED (IPC)<br><br>H03F |
| Y | US 2010/259331 A1 (DUSTER JON S [US] ET AL) 14 October 2010 (2010-10-14)<br>* abstract *<br>* figures 1,2 *<br>* paragraphs [0006] - [0018] *<br>----- | 1,3-7,<br>10-12 | |

-/--

The present search report has been drawn up for all claims

| Place of search | Date of completion of the search | Examiner |
|---|---|---|
| The Hague | 19 February 2016 | Mouanda, Thierry |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 15 18 4887

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | DOMENICO ZITO ET AL: "Dual-Input Pseudo-Switch RF Low Noise Amplifier", IEEE TRANSACTIONS ON CIRCUITS AND SYSTEMS II: EXPRESS BRIEFS, IEEE, US, vol. 57, no. 9, 1 September 2010 (2010-09-01), pages 661-665, XP011317381, ISSN: 1549-7747 * abstract * * figure 2 * * I. INTRODUCTION * * II. DILNA * | 1-13 | |
| A | KARTHIK JAYARAMAN ET AL: "A self-healing 2.4GHz LNA with on-chip S11/S21 measurement/calibration for in-situ PVT compensation", RADIO FREQUENCY INTEGRATED CIRCUITS SYMPOSIUM (RFIC), 2010 IEEE, IEEE, PISCATAWAY, NJ, USA, 23 May 2010 (2010-05-23), pages 311-314, XP031684149, ISBN: 978-1-4244-6240-7 * abstract * * figure 3 * * INTRODUCTION * * II. LNA DETECTION AND CALIBRATION * | 1,8,9 | |
| A | WO 99/45637 A1 (QUALCOMM INC [US]) 10 September 1999 (1999-09-10) * abstract * * page 13, line 8 - page 18, line 33 * | 1,11-13 | TECHNICAL FIELDS SEARCHED (IPC) |

The present search report has been drawn up for all claims

| Place of search | Date of completion of the search | Examiner |
|---|---|---|
| The Hague | 19 February 2016 | Mouanda, Thierry |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

 

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 15 18 4887

This annex lists the patent family members relating to the patent documents cited in the above-mentioned European search report.
The members are as contained in the European Patent Office EDP file on
The European Patent Office is in no way liable for these particulars which are merely given for the purpose of information.

19-02-2016

| Patent document cited in search report | | | Publication date | Patent family member(s) | | | Publication date |
|---|---|---|---|---|---|---|---|
| US 8456241 | | B1 | 04-06-2013 | US | 8242847 | B1 | 14-08-2012 |
| | | | | US | 8456241 | B1 | 04-06-2013 |
| US 2008204142 | | A1 | 28-08-2008 | KR | 100829780 | B1 | 16-05-2008 |
| | | | | US | 2008204142 | A1 | 28-08-2008 |
| US 2010259331 | | A1 | 14-10-2010 | TW | 201136144 | A | 16-10-2011 |
| | | | | US | 2010259331 | A1 | 14-10-2010 |
| | | | | WO | 2010120594 | A2 | 21-10-2010 |
| WO 9945637 | | A1 | 10-09-1999 | AU | 2986199 | A | 20-09-1999 |
| | | | | BR | 9908439 | A | 18-12-2001 |
| | | | | CA | 2322787 | A1 | 10-09-1999 |
| | | | | CN | 1299531 | A | 13-06-2001 |
| | | | | EP | 1058963 | A1 | 13-12-2000 |
| | | | | FI | 20001942 | A | 06-11-2000 |
| | | | | HK | 1035080 | A1 | 25-06-2004 |
| | | | | JP | 2002506304 | A | 26-02-2002 |
| | | | | TW | 437183 | B | 28-05-2001 |
| | | | | US | 6175279 | B1 | 16-01-2001 |
| | | | | WO | 9945637 | A1 | 10-09-1999 |
| | | | | ZA | 9901713 | A | 24-11-1999 |

EPO FORM P0459

For more details about this annex : see Official Journal of the European Patent Office, No. 12/82